# EUROPEAN PATENT APPLICATION

(11) **EP 4 839 025 A1**
(43) Date of publication of application: **11.11.2026**
(21) Application number: 25736246.7
(22) Date of filing: 02.01.2025
(51) Int. Cl.: H05K 1/02, H05K 1/14, H05K 1/18

(54) **FLEXIBLE CIRCUIT BOARD, COF MODULE, AND ELECTRONIC DEVICE COMPRISING SAME**

(30) Priority: 02.01.2024 KR 20240000413
(71) Applicant: LG Innotek Co., Ltd., Seoul 07796 (KR)
(72) Inventor: PARK, Ki Tae, Seoul 07796 (KR); KANG, Chae Won, Seoul 07796 (KR); KIM, Dong Chan, Seoul 07796 (KR)
(74) Representative: DREISS Patentanwälte PartG mbB
(86) International application number: PCT/KR2025/000028
(87) International publication number: WO 2025/147092

(57) **Abstract**

A flexible circuit board according to an embodiment comprises a substrate; a plurality of circuit patterns disposed on the substrate; and a protective layer disposed on the plurality of circuit patterns and having an opening, wherein the plurality of circuit patterns include a plurality of routing pad parts disposed within the opening and a plurality of routing wiring parts connecting the plurality of routing pad parts, and wherein the plurality of routing wiring parts include: a first routing wiring part disposed outside the opening and covered with the protective layer and connecting the plurality of routing pad parts, and a second routing wiring part disposed inside the opening and connecting the plurality of routing pad parts.

## Description

### Technical Field

An embodiment relates to a flexible circuit board, a COF module and an electronic device including the same.

### Background Art

Recently, various electronic products are becoming thinner and smaller. Accordingly, it is required to mount semiconductor chips in a narrow region of the electronic product at a high density.

A COF (Chip On Film) includes a circuit board and a chip disposed on the circuit board. The circuit board is flexible. That is, the COF is a flexible circuit board. Accordingly, the COF is applied to a flexible display. For example, the COF can be applied to various wearable electronic devices. In addition, the COF has a fine pitch. Accordingly, the COF is applied to a display having a high resolution.

The chip includes a semiconductor chip. For example, the chip can be an integrated circuit (IC) chip or a large scale integrated circuit (LSI) chip.

The chip is connected to an external circuit board and a display panel through a circuit pattern. For example, pad portions are provided at each one end and other end of the circuit pattern. One pad portion is electrically connected to a terminal of the chip. Another pad portion is connected to terminals of the external circuit board and the display panel. Accordingly, the chip, the external circuit board, and the display panel are electrically connected through the COF. Accordingly, a signal is transmitted to the display panel through the circuit pattern.

The chips mounted on the flexible printed circuit board are disposed in a multilayer structure and perform a role in each of the multilayer structures.

Recently, FLR (Film Level Route) technology has been applied. The FLR (Film Level Route) is to directly dispose a circuit pattern connected to one chip among the chips of the multilayer structure on the flexible printed circuit board. Since the routing pattern is disposed in the chip mounting region, a size of a layer structure of the chip is reduced. Accordingly, a manufacturing cost of the chip is reduced.

The FLR (Film Level Route) is a power line through which high voltage flows. Accordingly, the FLR (Film Level Route) may be damaged by the high voltage. In particular, an outer region of the FLR (Film Level Route) may be more vulnerable to the high voltage.

Therefore, a new flexible circuit board, COF module, and electronic device including the same that can solve the above problems are required.

As a patent related to the flexible circuit board, Korean Patent No. KR10-0618898 (2006.09.01) is disclosed.

### Disclosure

### Technical Problem

The embodiment provides a flexible circuit board having improved reliability.

### Technical Solution

A flexible circuit board according to an embodiment comprises a substrate; a plurality of circuit patterns disposed on the substrate; and a protective layer disposed on the plurality of circuit patterns and having an opening, wherein the plurality of circuit patterns include a plurality of routing pad parts disposed within the opening and a plurality of routing wiring parts connecting the plurality of routing pad parts, and wherein the plurality of routing wiring parts include: a first routing wiring part disposed outside the opening and covered with the protective layer and connecting the plurality of routing pad parts, and a second routing wiring part disposed inside the opening and connecting the plurality of routing pad parts.

In addition, the first routing wiring part is disposed in at least one region among an upper portion of the opening, a lower portion of the opening, and a side portion of the opening based on a horizontal direction.

In addition, the first routing wiring part includes a first-first routing wiring part and a first-second routing wiring part spaced apart from each other, and the first-second routing wiring part is disposed to surround the first-first routing wiring part on the substrate.

In addition, a width of the first-first routing wiring part and a width of the first-second routing wiring part are different from each other.

In addition, the width of the first-first routing wiring part is greater than the width of the first-second routing wiring part.

In addition, the width of the first-first routing wiring part is 2 to 10 times the width of the first-second routing wiring part.

In addition, the second routing wiring part includes a second-first routing wiring part disposed inside the opening and connected to the first-first routing wiring part, and a second-second routing wiring part disposed inside the opening to be spaced from the second-first routing wiring part and connected to the first-second routing wiring part.

In addition, the second routing wiring part is disposed inside the opening to be spaced from the second-first routing wiring part and the second-second routing wiring part, and is not connected to the first routing wiring part.

In addition, the second-first routing wiring part includes regions having different widths.

In addition, the second-first routing wiring part includes a first region having a first width, and a second region having a second width smaller than the first width, and the first region of the second-first routing wiring part is connected to the first-first routing wiring part.

In addition, the first-first routing wiring part has a third width greater than the second width.

In addition, the second-second routing wiring part has a fourth width smaller than the first width.

In addition, the fourth width is smaller than the third width.

In addition, the second-third routing wiring part has a fifth width smaller than the first width.

In addition, the fifth width is smaller than the third width.

In addition, a first length of the first-first routing wiring part is greater than a second length of the first region of the second-first routing wiring part.

In addition, the first length is 55% to 90% of a sum of the first length and the second length.

In addition, the sum of the first length and the second length is 250um to 300um.

Meanwhile, a COF module according to an embodiment comprises a flexible circuit board; and a chip disposed on the flexible circuit board, wherein the flexible circuit board comprises: a substrate; a plurality of circuit patterns disposed on the substrate; and a protective layer disposed on the plurality of circuit patterns and having an opening, wherein the plurality of circuit patterns include a plurality of routing pad parts disposed within the opening and a plurality of routing wiring parts connecting the plurality of routing pad parts, wherein the plurality of routing wiring parts include a first routing wiring part disposed on an outside of the opening and covered with the protective layer and connecting the plurality of routing pad parts, and a second routing wiring part disposed on an inside of the opening and connecting the plurality of routing pad parts, and wherein the chip is connected to the plurality of routing pad parts.

### Advantageous Effects

The flexible circuit board according to the embodiment includes a fourth circuit pattern. The fourth circuit pattern may be a routing pattern. Accordingly, a high voltage current may flow through the fourth circuit pattern.

The fourth circuit pattern includes a plurality of routing wiring parts and a plurality of routing pad parts. The routing wiring part includes a first routing wiring part disposed outside an open region and a second routing wiring part disposed inside the open region.

A size of the first routing wiring part is greater than sizes of other wiring parts. Accordingly, the fourth circuit pattern can be prevented from being damaged by a high voltage current.

In addition, a length of the first routing wiring part can have a set size. Accordingly, the embodiment can prevent the protective layer from being covered on the wiring part by the first routing wiring part.

Accordingly, the embodiment can prevent a size of the open region or chip mounting region from increasing by the protective layer.

### Description of Drawings

FIG. 1 is a top view of a flexible circuit board according to an embodiment.

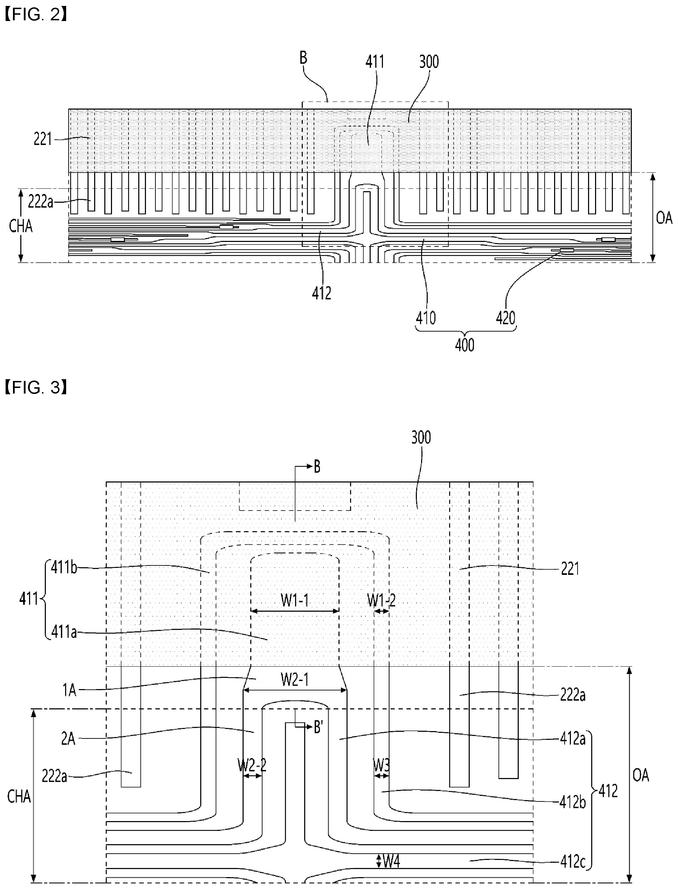

FIG. 2 is an enlarged view of region A of FIG. 1.
FIG. 3 is an enlarged view of region B of FIG. 2.
FIG. 4 is a cross-sectional view taken along region B-B' of FIG. 3.
FIG. 5 and FIG. 6 are cross-sectional views taken along region A-A' of FIG. 1.
FIG. 7 is a view for explaining a connection between a COF module and other components according to an embodiment.
FIG. 8 to FIG. 10 are views of an electronic device including a flexible circuit board according to an embodiment.

### Modes of the Invention

Hereinafter, embodiments of the present invention will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and redisposed.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", or "coupled" to another element, it may include not only when the element is directly "connected" to, or "coupled" to other elements, but also when the element is "connected", or "coupled" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

In addition, in the following description, a first direction 1D may be defined as a width direction of the flexible circuit board, and a second direction 2D may be defined as a length direction of the flexible circuit board.

Hereinafter, a flexible circuit board according to an embodiment and a COF module including the same will be described with reference to the drawings.

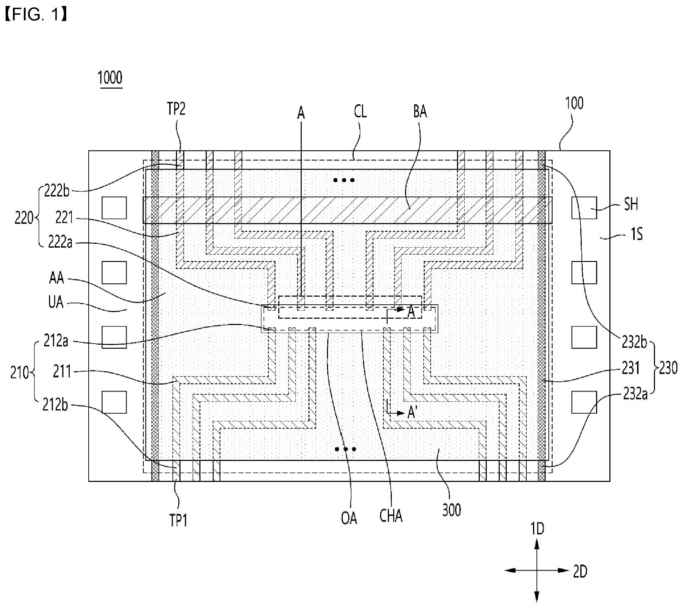

Referring to FIG. 1, a flexible circuit board 1000 according to an embodiment includes a substrate 100, a circuit pattern, and a protective layer 300.

The substrate 100 includes a first surface 1S and a second surface 2S opposite to the first surface 1S. The circuit pattern and the protective layer 300 are disposed on the first surface 1S.

The substrate 100 includes a cutting line CL. The flexible circuit board 1000 is cut along the cutting line CL. For example, the circuit pattern, the metal pattern, the protective layer, and the chip are disposed on the substrate 100. Thereafter, the substrate 100 is cut along the cutting line CL. Accordingly, a COF module is manufactured. Accordingly, an edge of the COF module becomes the cutting line CL.

The substrate 100 includes an effective region AA and an ineffective region UA. In detail, the first surface 1S includes the effective region AA and the ineffective region UA.

The effective region AA and the ineffective region UA are separated by the cutting line CL. The effective region AA is an inner region of the cutting line CL. In addition, the ineffective region UA is an outer region of the cutting line CL.

The circuit pattern, the protective layer, and the chip are disposed on the effective region AA. In addition, a dummy pattern and a sprocket hole SH are disposed on the ineffective region UA. The dummy pattern increases a rigidity of the substrate 100. In addition, the flexible circuit board 1000 is rolled or unrolled in a roll-to-roll manner by the sprocket hole SH.

The substrate 100 includes an open region OA and a chip mounting region CHA.

The open region OA is disposed on the effective region AA. The open region OA is disposed inside the substrate 100. The open region OA is distinguished by whether the protective layer is disposed. The protective layer is not disposed on the open region OA. That is, the open region OA can correspond to an opening provided in the protective layer. Therefore, the 'open region OA' of the substrate 100 can be referred to as an 'opening' of the protective layer.

The chip mounting region CHA is disposed on the open region OA. That is, the chip mounting region CHA is a part of the open region OA. The chip mounting region CHA is disposed on the first surface 1S. The chip mounting region CHA is disposed on the effective region AA. The chip CH is disposed on the chip mounting region CHA. In addition, pad parts of the circuit pattern are disposed inside the chip mounting region CHA.

The substrate 100 includes a flexible material. For example, the substrate 100 may include polyimide (PI). However, the embodiment is not limited thereto. The substrate 100 may include a polymer material including polyethylene terephthalate (PET) or polyethylene naphthalate (PEN). Accordingly, the flexible circuit board may be applied to various electronic devices including a curved display device.

The substrate 100 may have a thickness of 20 µm to 100 µm. For example, the substrate 100 may have a thickness of 25 µm to 50 µm. For example, the substrate 100 may have a thickness of 30 µm to 40 µm. If the thickness of the substrate 100 exceeds 100 µm, an overall thickness of the flexible circuit board increases. As a result, flexible characteristic of the flexible circuit board may be reduced. In addition, if the thickness of the substrate 100 is less than 20um, the substrate 100 may be damaged by heat and pressure applied to the substrate when the chip is mounted on the flexible circuit board.

The circuit pattern and the protective layer 300 are disposed on the substrate 100. In detail, the circuit pattern and the protective layer 300 are disposed on the first surface 1S. In detail, the circuit pattern and the protective layer 300 are disposed on at least one region among the effective region AA and the ineffective region UA.

The circuit pattern includes a first circuit pattern 210, a second circuit pattern 220, a third circuit pattern 230, and a fourth circuit pattern 400.

Referring to FIG. 1, the first circuit pattern 210 includes a first wiring part 211, a first pad part 212a, and a second pad part 212b. The first wiring part 211, the first pad part 212a, and the second pad part 212b may include a same material. In addition, the first wiring part 211, the first pad part 212a, and the second pad part 212b may be formed integrally.

The first pad part 212a is disposed inside the chip mounting region CHA. Accordingly, the first pad part 212a is connected to a terminal of the chip. Accordingly, the first circuit pattern 210 and the chip are connected.

The second pad part 212b is disposed outside the chip mounting region CHA. The second pad part 212b is connected to a pad part of a circuit board 3000. Accordingly, the first circuit pattern 210 and the circuit board 3000 are connected.

The first wiring part 211 is disposed between the first pad part 212a and the second pad part 212b. The first wiring part 211 connects the first pad part 212a and the second pad part 212b. Accordingly, the chip CH and the circuit board 3000 are connected. Accordingly, a signal generated from the chip CH is transmitted to the circuit board 3000.

The first circuit pattern 210 may further include a test pad part. In detail, a first test pad part TP1 is disposed in the ineffective region UA. The first wiring part 211, the first pad part 212a, the second pad part 212b, and the first test pad part TP1 may be formed integrally.

Before connecting the circuit board and the second pad part 212b, the first circuit pattern 210 can be tested by the first test pad part TP1. For example, the first test pad part TP1 can be used to check whether the first circuit pattern is open or shorted.

The second circuit pattern 220 includes a second wiring part 221, a third pad part 222a, and a fourth pad part 222b. The second wiring part 221, the third pad part 222a, and the fourth pad part 222b may include a same material. In addition, the second wiring part 221, the third pad part 222a, and the fourth pad part 222b may be formed integrally.

The third pad part 222a is disposed inside the chip mounting region CHA. Accordingly, the third pad part 222a is connected to a terminal of the chip. Accordingly, the second circuit pattern 220 and the chip CH are connected.

The fourth pad part 222b is disposed outside the chip mounting region CHA. The fourth pad part 222b is connected to a pad part of the external display panel 4000. Accordingly, the second circuit pattern 220 and the display panel 4000 are connected.

The second wiring part 221 is disposed between the third pad part 222a and the fourth pad part 222b. The second wiring part 221 connects the third pad part 222a and the fourth pad part 222b. Accordingly, the chip CH and the display panel 4000 are connected. Accordingly, a signal generated from the chip CH is transmitted to the display panel 4000.

The second circuit pattern 220 may further include a test pad part. In detail, a second test pad part TP2 is disposed on the ineffective region UA. The second test pad part TP2 is disposed outside the cutting line CL. The second test pad part TP2 is disposed on the ineffective region UA. The second wiring part 221, the third pad part 222a, the fourth pad part 222b, and the second test pad part TP2 can be formed integrally.

Before connecting the circuit board and the fourth pad part 222b, the second circuit pattern 220 can be tested by the second test pad part TP2. For example, the second test pad part TP2 may be used to check whether the second circuit pattern is open or shorted.

The third circuit pattern 230 includes a third wiring part 231, a fifth pad part 232a, and a sixth pad part 232b. The third wiring part 231, the fifth pad part 232a, and the sixth pad part 232b may include a same material. In addition, the third wiring part 231, the fifth pad part 232a, and the sixth pad part 232b may be formed integrally.

The fifth pad part 232a and the sixth pad part 232b are disposed outside the chip mounting region CHA. The fifth pad part 232a may be connected to the pad part of the circuit board 2000. In addition, the sixth pad part 232b may be connected to the pad part of the display panel 4000.

The third wiring part 231 is disposed between the fifth pad part 232a and the sixth pad part 232b. The third wiring part 231 connects the fifth pad part 232a and the sixth pad part 232b. Accordingly, the circuit board 3000 and the display panel 4000 are connected.

The third circuit pattern 230 may be a bypass circuit. For example, the third circuit pattern 230 may be a power supply pattern. Accordingly, a power may be supplied to the circuit board and the display panel by the third circuit pattern 230.

The third circuit pattern 230 may include a plurality of third circuit patterns spaced apart in the second direction 2D. A line width and spacing of the third circuit pattern 230 may be greater than a line width and spacing of the first circuit pattern 210. In addition, the line width and spacing of the third circuit pattern 230 may be greater than the line width and spacing of the second circuit pattern 220.

The protective layer 300 is disposed on the first surface 1S. Accordingly, the protective layer 300 is disposed on the first circuit pattern 210, the second circuit pattern 220, and the third circuit pattern 230. The protective layer 300 is disposed on the first wiring part 211, the second wiring part 221, and the third wiring part 231. The protective layer 300 is not disposed on the first pad part 212a, the second pad part 212b, the third pad part 222a, the fourth pad part 222b, the fifth pad part 232a, and the sixth pad part 232b. In addition, the protective layer 300 is not disposed on the chip mounting region CHA.

The fourth circuit pattern 400 is disposed on the effective region AA. The fourth circuit pattern 400 may be a routing pattern. That is, the fourth circuit pattern 400 may be a routing pattern that functions as one layer among layers of a chip having multiple layers disposed on the chip mounting region CHA.

That is, a target to which the fourth circuit pattern 400 is connected is different from a target to which the first circuit pattern 210 to the third circuit pattern 230 are connected. The fourth circuit pattern 400 is connected only to a terminal of the chip. The fourth circuit pattern 400 is not connected to the display panel and the circuit board.

A pad part of the first circuit pattern 210 to the third circuit pattern 230 is connected to the chip. In addition, other pad parts of the first circuit pattern 210 to the third circuit pattern 230 are connected to the circuit board or display panel.

The fourth circuit pattern 400 may be a routing circuit pattern. That is, the fourth circuit pattern 400 may have a structure in which a plurality of routing pad parts 420 are disposed within the opening of the protective layer, and the plurality of routing pad parts 420 may be electrically connected through a plurality of routing wiring parts 410 constituting the fourth circuit pattern 400. Hereinafter, the routing circuit pattern will be described as the fourth circuit pattern 400.

The fourth circuit pattern 400 includes a plurality of routing wiring parts 410 and a plurality of routing pad parts 420. The plurality of routing wiring parts 410 are spaced apart from each other. The routing pad parts 420 are connected to each of the routing wiring parts 410.

The fourth circuit pattern 400 is disposed inside the open region OA and outside the open region OA. The routing wiring part 410 is disposed inside the open region OA and outside the open region OA. In addition, the routing pad part 420 is disposed inside the open region OA. The open region OA may also be referred to as an opening of a protective layer.

Accordingly, the routing wiring part 410 includes a first routing wiring part 411 and a second routing wiring part 412 distinguished according to location. The first routing wiring part 411 is disposed outside the open region OA. In addition, the second routing wiring part 412 is disposed inside the open region OA.

The first routing wiring part 411 and the second routing wiring part 412 are connected. The first routing wiring part 411 and the second routing wiring part 412 are formed integrally.

Therefore, the protective layer 300 is disposed on the first routing wiring part 411. In addition, the protective layer 300 is not disposed on the second routing wiring part 412.

The first routing wiring part 411 can be disposed at various locations based on the open region OA. In detail, the first routing wiring part 411 can be disposed at least one of upper, lower, and side portions of the open region OA based on a horizontal direction.

For example, the first routing wiring part 411 can be disposed at least one of the upper and lower portions of the open region OA. The second routing wiring part 412 extends in multiple directions. In detail, the second routing wiring part 412 extends in the first direction 1D and the second direction 2D. The second routing wiring part 412 is bent toward the first direction 1D with respect to the second direction 2D. The first routing wiring part 411 can be connected to the second routing wiring part 412 extending in the first direction 1D.

Alternatively, the first routing wiring part 411 can be disposed on the side portion of the open region OA. The first routing wiring part 411 may be disposed at least on one of left and right side portions of the open region OA. The first routing wiring part 411 may be connected to the second routing wiring part 412 extending in the second direction 2D.

The first routing wiring part 411 is disposed outside the open region OA and extends in a first direction 1D and the second direction 2D.

Hereinafter, it will be described as an example that the first routing wiring part 411 is disposed on an upper portion of the open region OA.

The first routing wiring part 411 may include at least one wiring part. For example, the first routing wiring part 411 may include a plurality of wiring parts spaced apart from each other. The first routing wiring part 411 may include a first-first routing wiring part 411a and a first-second routing wiring part 411b.

The first-first routing wiring part 411a is spaced apart from the first-second routing wiring part 411b. The first-first routing wiring part 411a is disposed inside the first-second routing wiring part 411b. The first-second routing wiring part 411b surrounds the first-first routing wiring part 411a.

A size of the first-first routing wiring part 411a and a size of the first-second routing wiring part 411b are different. In detail, a width of the first-first routing wiring part 411a and a width of the first-second routing wiring part 411b are different. In detail, the width W1-1 of the first-first routing wiring part 411a is greater than the width W1-2 of the first-second routing wiring part 411b.

For example, the width W1-1 of the first-first routing wiring part 411a may be at least twice the width W1-2 of the first-second routing wiring part 411b. In detail, the width W1-1 of the first-first routing wiring part 411a may be 2 to 10 times, 3 to 9 times, or 4 to 7 times the width W1-2 of the first-second routing wiring part 411b.

The first routing wiring part 411 is disposed outside the open region OA. The fourth circuit pattern 400 is connected to the chip (C). Accordingly, a high voltage current may flow through the routing wiring part 410. The routing wiring part 410 includes the first-first routing wiring part 411a having a large width. Accordingly, the first routing wiring part 411 can be prevented from being damaged by high-voltage current.

In addition, external electrostatic discharge (ESD) can be effectively blocked by the first-first routing wiring part 411a. That is, since the width of the first-first routing wiring part 411a increases, an area of the first routing wiring part 411 increases.

Therefore, a signal of the chip can be prevented from being interfered with by the electrostatic discharge. Therefore, the electrical characteristics of the COF module are improved.

The second routing wiring part 412 includes a plurality of wiring parts. For example, the plurality of second routing wiring parts 412 are spaced apart from each other. The second routing wiring part 412 may include a second-first routing wiring part 412a, a second-second routing wiring part 412b, and a second-third routing wiring part 412c.

The second-first routing wiring part 412a is connected to the first-first routing wiring part 411a. The second-second routing wiring part 412b is connected to the first-second routing wiring part 411b. The second-third routing wiring part 412c is not connected to the first-first routing wiring part 411a and the first-second routing wiring part 411b.

The second-first routing wiring part 412a includes a first region 1A and a plurality of second regions 2A. The first region 1A is connected to the first-first routing wiring part 411a. The second region 2A is connected to the first region 1A. In detail, the first region 1A is branched into at least two or more wiring parts, thereby forming a plurality of second regions 2A. Therefore, the first region 1A and the second region 2A are formed integrally. In addition, the first-first routing wiring part 411a and the second-first routing wiring part 412a are formed integrally.

The first region 1A and the second region 2A have different sizes. In detail, the first region 1A and the second region 2A have different widths. The width W2-1 of the first region 1A is greater than the width W2-2 of the second region 2A.

The width W2-1 of the first region 1A is the same as or similar to the width W1-1 of the first-first routing wiring part 411a. Therefore, the width W2-2 of the second region 2A is smaller than the width W1-1 of the first-first routing wiring part 411a.

The second-second routing wiring part 412b is connected to the second-first routing wiring part 411b. The first-second routing wiring part 411b and the second-second routing wiring part 412b are formed integrally.

A width W3 of the second-second routing wiring part 412b is the same as or similar to a width W1-2 of the first-second routing wiring part 411b. The width W3 of the second-second routing wiring part 412b is the same as or similar to the width W2-2 of the second region 2A. The width W3 of the second-second routing wiring part 412b is smaller than the width W2-1 of the first region 1A. The width W3 of the second-second routing wiring part 412b is smaller than the width W1-1 of the first-first routing wiring part 411a.

The second-third routing wiring part 412c is not connected to the first-first routing wiring part 411a and the first-second routing wiring part 411b. The second-third routing wiring part 412c is spaced apart from the second-first routing wiring part 412a and the second-second routing wiring part 412b.

A width W4 of the second-third routing wiring part 412c is the same as or similar to the width W1-2 of the first-second routing wiring part 411b. The width W4 of the second-third routing wiring part 412c is the same as or similar to the width W2-2 of the second region 2A. The width W4 of the second-third routing wiring part 412c is the same as or similar to the width W3 of the second-second routing wiring part 412b. The width W4 of the second-third routing wiring part 412c is smaller than the width W2-1 of the first region 1A. The width W4 of the second-third routing wiring part 412c is smaller than the width W1-1 of the first-first routing wiring part 411a.

A length of the first-first routing wiring part 411a is different from a length of the second-first routing wiring part 412a. In detail, a first length L1 of the first-first routing wiring part 411a is longer than a second length L2 of the first region 1A of the second-first routing wiring part 412a.

The first length L1 may be greater than 50% of a sum (L1+L2) of the first length and the second length. In detail, the first length L1 may be 55% to 90%, 60% to 85%, or 65% to 80% of the sum (L1+L2) of the first length and the second length.

The sum (L1+L2) of the first length and the second length may be 250 um to 300 um. The first length L1 may be 130 um to 280 um, 150 um to 250 um, or 180 um to 240 um.

A width of the first region 1A of the first-first routing wiring part 411a and a width of the second-first routing wiring part 412a is greater than the width of the other wiring parts of the fourth circuit pattern.

The protective layer 300 is formed by applying a liquid solder resist. Since the width of the first region 1A of the first-first routing wiring part 411a and the second-first routing wiring part 412a is large, the liquid solder resist is restricted from moving by the first region 1A of the first-first routing wiring part 411a and the second-first routing wiring part 412a.

Therefore, the liquid solder resist can cover the wiring part and pad part with a large width by naturally flowing in after being applied to the first-second routing wiring part 411b. In detail, the liquid solder resist can flow by 130 µm to 280 µm. Accordingly, the protective layer 300 is disposed on the first-first routing wiring part 411a and the second wiring part 221. Accordingly, the first length L1 is formed as much as the size of the solder resist flowing.

If the sum of the first length and the second length (L1+L2) exceeds 250 um to 300 um, the length of the second length L2 becomes longer. Accordingly, the wiring part is not sufficiently covered by the protective layer. Accordingly, the size of the chip mounting region increases, and the size of the COF module may also increase.

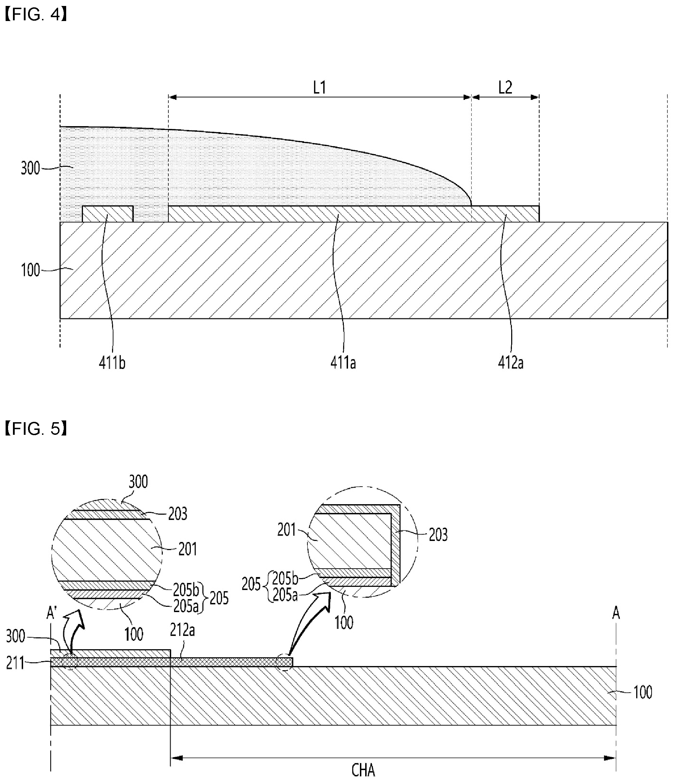

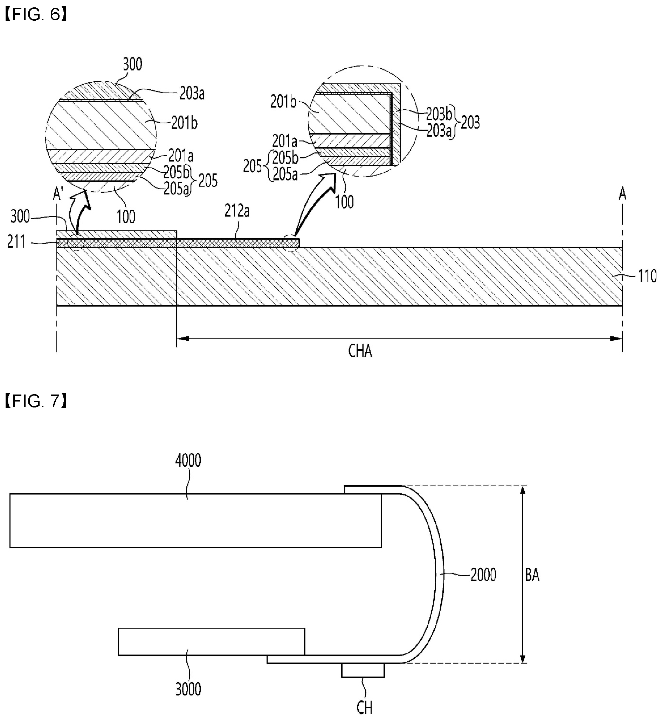

Referring to FIGS. 5 and 6, the circuit pattern is formed in a multilayer structure. FIGS. 5 and 6 will be described focusing on the first circuit pattern. The following description applies equally to the second and third circuit patterns.

Referring to FIG. 5, the first circuit pattern is formed in a multilayer structure. In detail, the first wiring part 211, the first pad part 212a, and the second pad part 212b include a buffer layer 205, a metal layer 201, and a bonding layer 203.

The buffer layer 205 may include multiple layers. In detail, the buffer layer 205 includes a first buffer layer 205a and a second buffer layer 205b. The first buffer layer 205a is disposed on the substrate 100. The second buffer layer 205b is disposed on the first buffer layer 205a.

The first buffer layer 205a includes a material having good adhesion to the substrate 100. For example, the first buffer layer 205a may include nickel (Ni). In addition, the second buffer layer 205b includes a material having good adhesion to the circuit pattern. For example, the second buffer layer 205b may include chromium (Cr).

The buffer layer 205 may have a thin film thickness in nanometer units. For example, the buffer layer 205 may have a thickness of 20nm or less.

An adhesion between the substrate 100 and the circuit pattern is improved by the buffer layer 205.

The metal layer 201 is disposed on the buffer layer 205. In detail, the metal layer 201 is disposed on the second buffer layer 205b. The metal layer 201 includes a metal material. For example, the metal layer 201 may include copper (Cu).

The metal layer 201 may be formed by electroplating using the buffer layer as a seed layer. That is, the metal layer 201 may be a plating layer.

A thickness of the metal layer 201 may be 10um to 30um.

The bonding layer 203 is disposed on the metal layer 201.

The bonding layer 203 is disposed on side and upper surfaces of the metal layer 201. For example, the bonding layer 203 may be disposed while surrounding the metal layer 201.

The bonding layer 203 includes a metal. For example, the bonding layer 203 may include tin (Sn). The bonding layer 203 is formed by a plating process. In detail, the bonding layer 203 may be a plating layer.

A thickness of the bonding layer 203 may be 0.3 um to 0.7 um. A tin content may increase from the lower surface of the bonding layer 203 toward the upper surface of the bonding layer 203.

That is, the bonding layer 203 is in contact with the metal layer 201. Therefore, the tin content increases from the lower surface of the bonding layer 203 toward the upper surface of the bonding layer 203. In addition, a copper content decreases from the lower surface of the bonding layer 203 toward the upper surface of the bonding layer 203.

Accordingly, pure tin may remain in a thickness range of 0.1 µm to 0.3 µm from the upper surface of the bonding layer 203.

The pad part can be easily bonded to the terminals of the chip, the circuit board, and the display panel by the bonding layer 203. For example, when heat and pressure are applied to the pad part, the upper surface of the bonding layer melts. Pure tin remains on the upper surface of the bonding layer. Therefore, the pad part can be easily bonded to the terminals of the chip, the circuit board, and the display panel.

Referring to FIG. 6, the metal layer 201 layer may include a first metal layer 201a and a second metal layer 201b. The first metal layer 201a is disposed on the buffer layer 205. The second metal layer 201b is disposed on the first metal layer 201a. The second metal layer 201b may be formed by electroplating using the first metal layer 201a as a seed layer. That is, the second metal layer 201b may be a plating layer.

A thickness of the first metal layer 201a may be smaller than a thickness of the second metal layer 201b.

For example, the thickness of the first metal layer 201a may be 0.7 um to 2 um, and the thickness of the second metal layer 201b may be 6 um to 25 um.

The first metal layer 201a and the second metal layer 201b may include a same metal material. For example, the first metal layer 201a and the second metal layer 201b may include copper (Cu).

The bonding layer 203 may include a first bonding layer 203a and a second bonding layer 203b.

The first bonding layer 203a is disposed on the metal layer 201. In detail, the first bonding layer 203a is disposed on the second wiring part 221, the third pad part 222a, and the fourth pad part 222b.

The second bonding layer 203b is disposed on the first bonding layer 203a. In detail, the second bonding layer 203b is disposed on the third pad part 222a and the fourth pad part 222b.

Therefore, the second wiring part 221 includes the buffer layer 205, the metal layer 201, and the first bonding layer 203a. In addition, the third pad part 222a and the fourth pad part 222b include the buffer layer 205, the metal layer 201, the first bonding layer 203a, and the second bonding layer 203b.

Therefore, a layer structure of the second wiring part 221 is different from layer structures of the first pad part 212a and the second pad part 212b.

The first bonding layer 203a and the second bonding layer 203b include metal. In detail, the first bonding layer 203a and the second bonding layer 203b may include tin (Sn).

The first bonding layer 203a and the second bonding layer 203b are disposed with different thicknesses. In detail, a thickness of the second bonding layer 203b is greater than a thickness of the first bonding layer 203a.

For example, the first bonding layer 203a has a thickness of 0.02 µm to 0.06 µm. In addition, the second bonding layer 203b has a thickness of 0.2 µm to 0.6 µm.

Accordingly, the thickness of the first wiring part 211 is reduced. The flexible circuit board includes a bending region BA that is bent in one region. The wiring part is disposed on the bending region BA. Therefore, the thickness of the bonding layer on the wiring part is formed small. Accordingly, when the flexible circuit board is bent, it is possible to prevent cracks from forming in the first wiring part 211.

The thickness of the circuit pattern may be greater than 8 um to 25 um. In detail, the thickness of the circuit pattern may be 9 um to 20 um. In detail, the thickness of the circuit pattern may be 10 um to 15 um.

If the thickness of the circuit pattern is less than 8 um, the resistance of the circuit pattern may increase. In addition, if a high current flows through the display panel, the circuit pattern may be damaged. If the thickness of the circuit pattern exceeds 25 um, it becomes difficult to implement a fine pattern.

Referring to FIG. 7, one end of the COF module 2000 is connected to the display panel 4000, and another end is connected to the circuit board 3000. For example, the display panel 4000 and the circuit board 3000 are disposed on one surface of the COF module 2000. However, the embodiment is not limited thereto. The display panel 4000 and the circuit board 3000 may be disposed on another surface of the COF module 2000. In this case, the COF module 2000 may have circuit patterns disposed on each of both surfaces. For example, the COF module 2000 may include a first circuit pattern and a second circuit pattern disposed on a first surface, and a second circuit pattern and a third circuit pattern disposed on the second surface. The second circuit patterns may be connected to each other through vias.

Since the COF module 2000 includes a flexible substrate, it has a rigid shape and a bent shape between the display panel 3000 and the circuit board 4000. That is, the COF module 2000 may include a bending region BA.

The COF module 2000 connects the display panel 4000 and the circuit board 3000 that are disposed opposite each other in a bent shape. Therefore, the thickness of the electronic device is reduced. In addition, the design freedom of the electronic device is improved. In addition, a wiring of the COF module 2000 is not broken even in a bent shape. Accordingly, the reliability of the electronic device is improved.

Since the COF module is flexible, it is applied to various electronic devices.

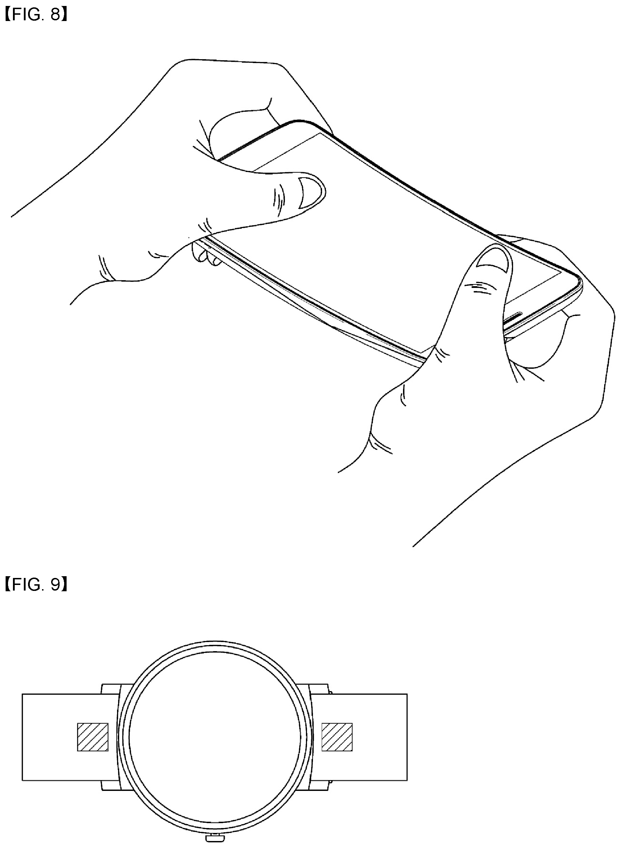

Referring to FIG. 8, the COF module can be applied to a flexible touch window that bends. Accordingly, the touch device including the COF module may be a flexible touch device. Therefore, the user can bend or fold the COF module by a hand. Such a flexible touch window can be applied to wearable touch, etc.

Referring to FIG. 9, the COF module may be applied to various wearable touch devices including a curved display. Accordingly, the wearable touch device may be slimmed down or made lightweight.

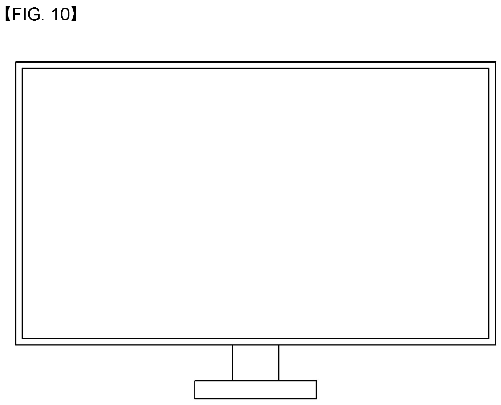

Referring to FIG. 10, the COF module may be applied to various electronic devices having a display portion such as a TV, a monitor, and a laptop. At this time, the COF module can also be used in an electronic device having a curved display portion.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A flexible circuit board comprising:
a substrate;
a plurality of circuit patterns disposed on the substrate; and
a protective layer disposed on the plurality of circuit patterns and having an opening,
wherein the plurality of circuit patterns include a plurality of routing pad parts disposed within the opening and a plurality of routing wiring parts connecting the plurality of routing pad parts, and
wherein the plurality of routing wiring parts include:
a first routing wiring part disposed outside the opening and covered with the protective layer and connecting the plurality of routing pad parts, and a second routing wiring part disposed inside the opening and connecting the plurality of routing pad parts.

2. The flexible circuit board of claim 1, wherein the first routing wiring part is disposed in at least one region among an upper portion of the opening, a lower portion of the opening, and a side portion of the opening based on a horizontal direction.

3. The flexible circuit board of claim 1, wherein the first routing wiring part includes a first-first routing wiring part and a first-second routing wiring part spaced apart from each other, and
wherein the first-second routing wiring part is disposed to surround the first-first routing wiring part on the substrate.

4. The flexible circuit board of claim 3, wherein a width of the first-first routing wiring part and a width of the first-second routing wiring part are different from each other.

5. The flexible circuit board of claim 4, wherein the width of the first-first routing wiring part is greater than the width of the first-second routing wiring part.

6. The flexible circuit board of claim 5, wherein the width of the first-first routing wiring part is 2 to 10 times the width of the first-second routing wiring part.

7. The flexible circuit board of claim 5, wherein the second routing wiring part includes a second-first routing wiring part disposed inside the opening and connected to the first-first routing wiring part, and a second-second routing wiring part disposed inside the opening to be spaced from the second-first routing wiring part and connected to the first-second routing wiring part.

8. The flexible circuit board of claim 7, wherein the second routing wiring part is disposed inside the opening to be spaced from the second-first routing wiring part and the second-second routing wiring part, and is not connected to the first routing wiring part.

9. The flexible circuit board of claim 8, wherein the second-first routing wiring part includes regions having different widths.

10. The flexible circuit board of claim 9, wherein the second-first routing wiring part includes a first region having a first width, and a second region having a second width smaller than the first width, and
wherein the first region of the second-first routing wiring part is connected to the first-first routing wiring part.
